# EUROPÄISCHE PATENTSCHRIFT

(11) **EP 0 338 502 B1**
(45) Veröffentlichungstag und Bekanntmachung des Hinweises auf die Patenterteilung: **31.08.1994**
(21) Anmeldenummer: 89106911.4
(22) Anmeldetag: 18.04.1989
(51) Int. Cl.: H05K 13/04

(54) **Gerät zum Bestücken und/oder Verlöten bzw. Verkleben von elektronischen Bauelementen, insbesondere SMD-Bauelementen, auf Leiterplatten**
Device for mounting and/or soldering or gluing electronic components, particularly SMD-components, on printed circuit boards
Dispositif de montage et/ou de soudage ou de collage de composants électroniques, en particulier de composants CMS, sur circuits imprimés

(30) Priorität: 19.04.1988 DE 3813096
(43) Veröffentlichungstag der Anmeldung: 25.10.1989
(73) Patentinhaber: Fritsch, Adalbert, D-92280 Kastl (DE)
(72) Erfinder: Fritsch, Adalbert, D-92280 Kastl (DE)
(74) Vertreter: Schmidt-Evers, Jürgen, Dipl.-Ing.

(56) Entgegenhaltungen:
- US-A- 4 459 743

## Beschreibung

Die Erfindung bezieht sich auf ein Gerät nach dem Oberbegriff der Ansprüche 1 und 2.

Es ist ein Gerät dieser Art bekannt, bei dem die zu bestückende Leiterplatte in einem ersten Träger aufgenommen ist und die Bauelemente mittels eines zweiten Trägers einem Magazin entnommen und auf der Leiterplatte abgesetzt werden. Der zweite Träger umfaßt ein an einem Bestückungskopf angeordnetes Bestückungswerkzeug, das in einer horizontalen Kreuzführung parallel zur Ebene der Leiterplatte und in einer Vertikalführung quer zur Ebene der Leiterplatte, nämlich senkrecht von Hand verstellbar ist, um das betreffende Bauelement aus dem Magazin entnehmen und auf der Leiterplatte absetzen zu können. Bei dem Bestückungswerkzeug kann es sich um eine an eine Vakuumquelle angeschlossene Saugnadel handeln, an deren Saugspitze die Bauelemente mittels Saugluft ergriffen werden können. Die Saugnadel kann beim Aufdrücken des von ihr getragenen Bauelementes auf die Leiterplatte ein kurzes Stück in ihrer Längsrichtung verschoben werden und betätigt dabei einen Schalter, der die Vakuumquelle abschaltet, so daß das Bauelement freigegeben wird. Umgekehrt kann die Saugnadel, wenn die Vakuumquelle abgeschaltet ist, auf ein auf der Leiterplatte befindliches Bauelement aufgesetzt und auf dieses aufgedrückt werden, wodurch wiederum der Mikroschalter betätigt und die Vakuumquelle eingeschaltet wird. Dadurch kann das Bauelement mit der Nadel von der Leiterplatte abgenommen werden, wenn es von seiner Lötunterlage frei ist.

Beim Aufsetzen eines Bauelementes auf die Leiterplatte stützt sich die Bedienungsperson mit dem Ballen der am Bestückungskopf angreifenden Hand auf einer am Gerät vorgesehenen Unterlage ab. Die Bedienungshand neigt deshalb dazu, beim Absenken des Bestückungskopfes eine bogenförmige Bewegung auszuführen. Diese bogenförmige Bewegung führt in der letzten Phase des Absenkens des Bestückungskopfes, also wenn das betreffende Bauelement die Leiterplatte bereits berüht hat, aber der Bestückungskopf noch weiter abgesenkt wird, leicht zu einer seitlichen Verschiebung des Bauelementes auf der Leiterplatte, was unerwünscht ist. Bei der heute geforderten hohen Präzision, insbesondere für das Plazieren von SMD(small mounted device)-Bauelementen kann dies zu Fehlbeschaltungen führen.

Eine seitliche Verschiebung des Bauelementes nach seinem Aufsetzen auf der Leiterplatte ist auch grundsätzlich möglich aufgrund der vorgegebenen mehr oder weniger starken Labilität der Bedienungshand, insbesondere bei ungeübten Bedienungspersonen. Es bedarf nämlich einer bedeutenden Aufmerksamkeit und Anstrengung, den Bestückungskopf nach dem Ausetzen des Bauelementes auf die Leiterplatte zu halten und zwar insbesondere dann, wenn dieses Halten einen längeren Zeitraum erfordert, was bei Reparatur von Leiterplatten oft vorkommt.

Ein weiteres Problem bei einem Gerät der eingangs bezeichneten Art, bei dem der Träger unter einer nach oben gerichten Vorspannung steht, die ihm nach dem Loslassen der Bedienungshand in seine obere Ausgangsposition zurückführt, besteht darin, daß die Bedienungshand während des Andrückens des Bauelementes an die Leiterplatte an den Träger gebunden ist. Dies gilt sowohl bei Bestückungsarbeiten als auch bei Reparaturarbeiten von bestückten Leiterplatten, bei denen defekte Bauelemente von der Leiterplatte entfernt bzw. abgelötet und durch gut funktionierende Bauelemente ersetzt werden sollen. Durch die Bindung der Bedienungshand an den quer zur Ebene der Leiterplatte verstellbaren Träger sind die sog. Arbeiten von der Bedienungsperson nur erschwert durchführbar.

Ein weiteres Gerät zum Bestücken von elektronischen Bandementen auf Leiterplatten ist aus US-A-4 459 743 bekannt.

Der Erfindung liegt die Aufgabe zugrunde, ein Gerät der eingangs bezeichneten Art so auszugestalten, daß vor oder nach dem Aufsetzen des Bauelementes auf die Leiterplatte quer und/oder längs zur Leiterplatte gerichtete Verschiebungen des Bauelementes bzw. dessen Trägers in wenigstens einer der Koordinatenrichtungen vermieden werden können.

Diese Aufgabe wird durch die kennzeichnenden Merkmale der Ansprüche 1 und 2 gelöst.

Bei der erfindungsgemäßen Ausgestaltung ist dem parallel zur Ebene der Leiterplatte verstellbaren Träger in wenigstens einer seiner beiden Verstellrichtungen eine Bremse zugeordnet, die wahlweise betätigbar ist oder auch dann betätigt wird, wenn das vom Träger gehaltene Bauelement die Oberfläche der zu bestückenden Leiterplatte berührt. Nach der Betätigung kann eine Verschiebung des Bauelementes nicht mehr erfolgen und zwar auch dann nicht, wenn der Träger weiter abwärts bewegt wird zwecks Andrucks des Bauelementes an die Leiterplatte. Wenn die Bewegung in nur einer Koordinatenrichtung gebremst wird, können in der anderen Koordinatenrichtung Bauelemente in Reihe gesetzt werden.

Die Erfindung ermöglicht auch eine Ausgestaltung, bei der es keines ständigen manuellen Eingriffs bedarf, um den gleichzeitigen Kontakt des auf die Leiterplatte aufgesetzten Bauelementes mit dem Träger und der Leiterplatte aufrechtzuerhalten.

Hierzu ist dem quer zur Ebene der Leiterplatte verstellbaren Träger eine ggf. weitere Bremse zugeordnet, welche es gestattet, den Träger in der abgesenkten Stellung zu arretieren. Dadurch ist es möglich, den gleichzeitigen Kontakt des Bauelementes mit dem Träger und der Leiterplatte aufrechtzuerhalten, ohne daß hierfür die Bedienungshand der Bedienungsperson erforderlich ist. Dies gilt sowohl beim Absetzen eines zu bestückenden Bauelementes auf die Leiterplatte als auch beim Entfernen eines Bauelementes von der Leiterplatte. Durch Betätigung der Bremse kann der Träger in der Arretierposition fixiert werden, ohne daß er von der Bedienungsperson gehalten werden muß. Letzte hat dadurch beide Hände zur Verfügung, um Befestigungs- bzw. Lösearbeiten oder Löt- bzw. Ablötarbeiten zu verrichten, wobei sie mit der einen Hand das Lötzinn und mit der anderen Hand einen Lötkolben oder auch einen Heißluftspender führen kann. Durch die Verwendung eines Lötkolbens anstatt Heißluft wird außerdem folgender Nachteil vermieden. Bei Reparaturarbeiten von bestückten Leiterplatten, bei denen defekte Bauelemente von der Leiterplatte abgelötet und durch gut funktionierende Bauelemente ersetzt werden sollen, wurde bisher häufig Heißluft zum Ablöten und Wiederanlöten der Bauelemente verwendet. Es hat sich jedoch insbesondere beim Wiederauflöten von funktionierenden Bauelementen herausgestellt, daß die Heißluft kugelförmige Teilchen oder Rückstände des Löt- und/oder Flußmittels an der Bestückungsstelle entstehen läßt, bzw. unter das neu einzusetzende Bauelement treibt, wodurch Kurzschlüsse entstehen oder sonstige Störungen verursacht werden können (beispielsweise Beeinflussung von Kapazitäten oder Induktivitäten) Bei der erfindungsgemäßen Ausgestaltung kann die Bedienungsperson in handhabungsfreundlicherweise einen Lötkolben verwenden, wodurch die vorbeschriebenen Nachteile ausgeschaltet werden können.

Die in den Ansprüchen 3 bis 26 enthaltenen Merkmale zeichnen sich durch eine einfache und kostengünstig herstellbare sowie kleine Bauweise, aus Gründen einfacher Handhabung und aus funktionellen Gründen aus. Es empfiehlt sich dabei, in beiden sich parallel zur Ebene der Leiterplatte verlaufenden Verstellrichtungen wirksame Bremsen vorzusehen, so daß die Bedienungsperson nicht nur in einer Verstell- bzw. Koordinatenrichtung sondern in beiden Richtungen entlastet bzw. freigestellt ist. Dies gilt insbesondere für die Verstellrichtung, die in Blickrichtung der Bedienungsperson liegt, und in der eine Kontrolle der genauen Position des aufgesetzten Bauelementes erschwert ist.

Im Rahmen der Erfindung ist es möglich, auch die in der quer zur Ebene der Leiterplatte verlaufenden Verstellrichtung wirksame Bremse manuell oder automatisch, z.B. durch einen Schalter in Funktion zu setzen. Eine manuelle Einschaltung ist deshalb vorteilhaft, weil zum einen diese Bremse wahlweise in Funktion gesetzt werden kann, was für bestimmte Bestückungs- bzw. Reparaturarbeiten von Vorteil ist und zum anderen bestimmte manuell erzeugte Druckmomente ausgenutzt werden können, die die Fixierung des Baulements auf der Leiter mittels des Trägers verbessern.

Nachfolgend wird die Erfindung anhand von in einer vereinfachten Zeichnung dargestellten Ausführungsbeispielen näher erläutert.

Es zeigt:
- Figur 1: ein erfindungsgemäß ausgestaltetes Gerät zum Bestücken und/oder Verlöten bzw. Verkleben von elektronischen Bauelementen auf Leiterplatten in perspektivischer Ansicht von vorne;
- Figur 2: eine Kreuzführung für einen einen Werkzeugkopf tragenden Führungsarm des Gerätes in der Draufsicht;
- Figur 3: eine erste Bremse und eine zweite Bremse für den Führungsarm im Teilschnitt III-III in Figur 2.
- Figur 4: eine Rückansicht des geöffneten Werkzeugkopfes;
- Figur 5: den Schnitt V-V in Figur 4;
- Figur 6: den Werkzeugkopf in der Vorderansicht;
- Figur 7: ein Magazin für das Gerät in der Draufsicht;
- Figur 8: den Schnitt VIII-VIII in Figur 7;
- Figur 9: einen Magazinkasten des Magazins in der Seitenansicht;
- Figur 10: einen elektrischen Schaltplan für das Gerät.
- Figur 11: eine abgewandelte Kreuzführung für den den Werkzeugkopf tragenden Führungsarm in der Draufsicht;
- Figur 12: den Schnitt XII-XII in Fig. 11;
- Figur 13: den Teilschnitt XIII-XIII in Figur 12;
- Figur 14: einen Kreuzschlitten als Einzelheit.

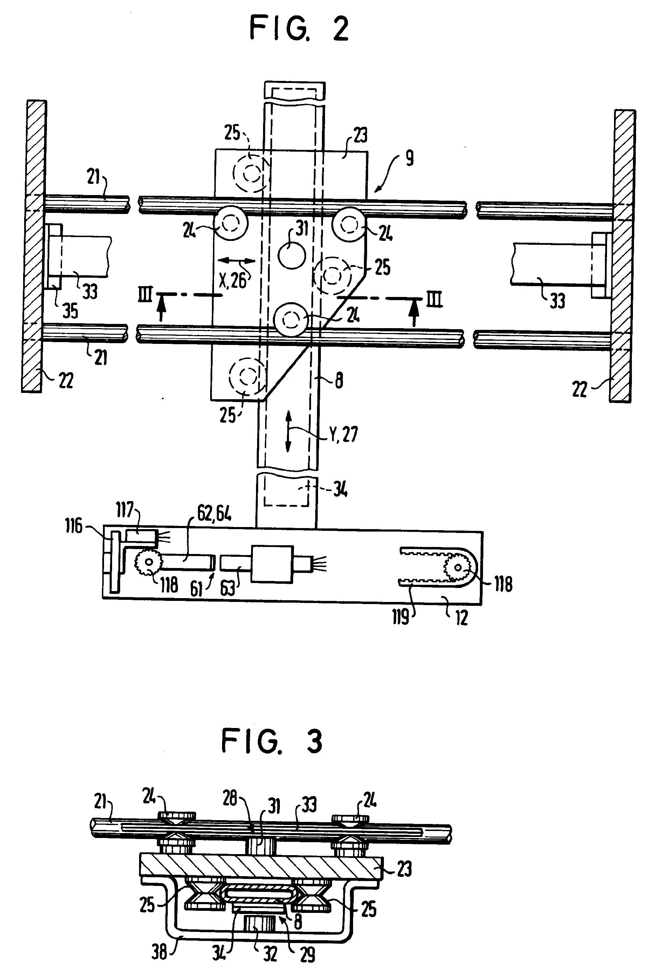

Die wesentlichen Teile des allgemein mit 2 bezeichneten Gerätes in Form eines Manipulators sind ein Halterahmen 3 für Leiterplatten 4, der bezüglich der Bedienungsseite 5 des Gerätes 2 vorn angeordnet ist, ein bezüglich des Halterahmens 3 zur Rückseite hin versetztes, sich parallel zur Bedienungsseite 5 erstreckendes rückenförmiges Führungsteil 6, an dessen waagerechtem Holm 7 unterseitig ein Führungsarm 8 in einer in Figur 2 dargestellten Kreuzführung 9 im wesentlichen rechtwinklig und parallel zur Bedienungsseite 5 verschiebbar gelagert ist, ein am zur Bedienungsseite 5 weisenden Ende des Führungsarmes 8 angeordneter Bestückungskopf 12 mit einem Griff 13, den die Bedienungsperson zwecks wahlweiser Verschiebung des Führungsarmes 8 parallel zur Ebene der Leiterplatte 4 ergreift, ein beim vorliegenden Ausführungsbeispiel links vom Halterahmen 3 angeordnetes Magazin 14 für elektronische Bauelemente 15 und ein rechts neben dem Halterahmen 3 angeordnetes Ablagegestell 16, das zwecks Anpassung an Leiterplatten 4 unterschiedlicher Größe längs der Bedienungsseite 5 auf einem den Halterahmen 3 tragenden Gestell 17 verschiebbar geführt ist, und auf den die den Bestückungskopf 12 führende Hand der Bedienungsperson abgestützt werden kann.

An der Frontseite des Holmes 7 sind die Funktion des Gerätes bestimmende Steuerelemente angeordnet.

Die Bewegungskoordinaten des Führungsarmes 8, auf denen das vom Werkzeugkopf 12 getragene Bestückungs-Werkzeug, das beim vorliegenden Ausführungsbeispiel eine Saugnadel 18 ist, in der Ebene der Leiterplatte 4 an jede Stelle im Koordinatensystem, d.h. an jede Stelle der Leiterplatte 4, verschoben werden kann, sind mit X und Y bezeichnet.

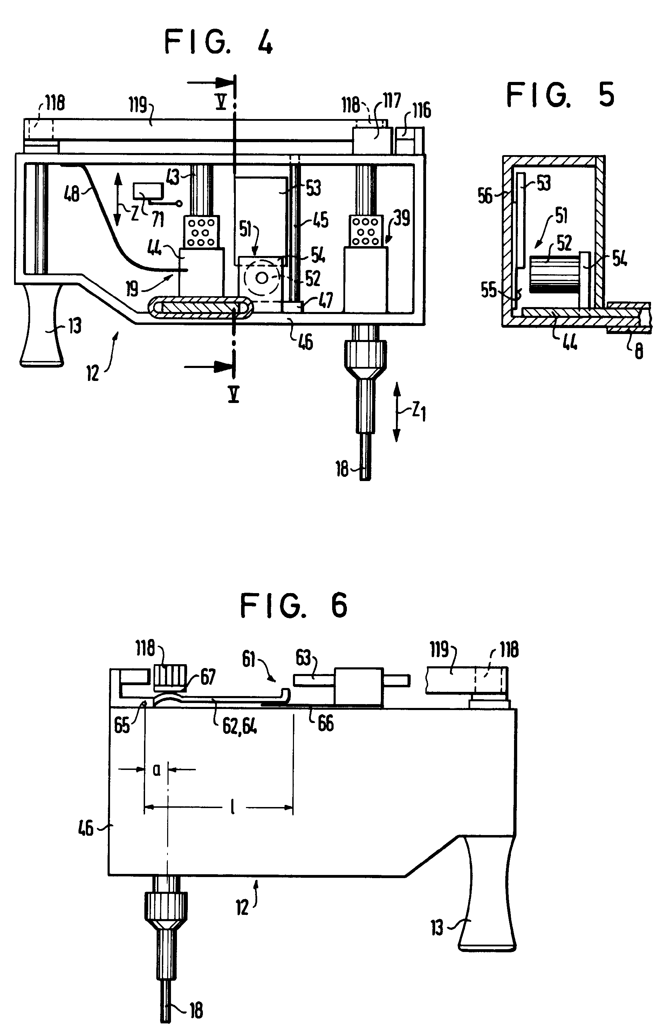

Es ist eine weitere senkrechte Bewegungsrichtung Z für das Bestückungswerkzeug vorgesehen, die beim vorliegenden Ausführungsbeispiel durch eine senkrechte Führung 19 (Fig. 4) zwischen dem Führungsarm 8 und dem Bestückungskopf 12 gebildet ist.

Die wesentlichen Teile der in Figur 2 dargestellten Kreuzführung 9 sind zwei Führungsschienen 21 in Form von Rundstangen, die sich parallel zur Achse X in horizontaler Ebene erstrecken und an den Seitenwangen 22 des Führungsteils 6 befestigt sind, eine Führungsplatte 23, die sich zwischen den Führungsschienen 21 und dem Führungsarm 8 erstreckt (Figur 3) und jeweils drei Führungsrollen 24,25, von denen die mit 24 bezeichneten Führungsrollen mit den Führungsschienen 21 zusammenwirken und die X-Führung 26 ergeben, während die mit 25 bezeichneten Führungsrollen mit dem Führungsarm 8 zusammenwirken und die Y-Führung 27 ergeben. Wie insbesondere aus Figur 3 ersichtlich ist, weisen die Führungsrollen 24,25, eine X-förmige Mantelfläche auf, mit der sie die Führungsschienen 21 und den seitlich gerundeten Führungsarm 8 umgreifen, so daß die Führung in der Horizontalen gesichert ist. Der Führungsarm 8 besteht aus einem abgeflachten Rohr, d.h. er weist ebene Ober- und Unterseiten sowie gerundete Seitenflächen auf. Die Führungsrollen 24,25 umgreifen die Führungsschienen 21 bzw. den Führungsarm 8 jeweils an drei Punkten, wodurch auf einfache Weise eine exakte Führung gewährleistet ist.

Der Kreuzführung 9 sind zwei Bremsen 28,29 zugeordnet, von denen die Bremse 28 eine wahlweise Blockierung der Bewegung der Führungsplatte 23 in der X-Richtung und die Bremse 29 eine wahlweise Blockierung der Bewegung des Führungsarmes 8 in der Y-Richtung ermöglicht. Die Bremsen 28,29 sind Elektromagnetbremsen mit jeweils einem Elektromagneten 31,32 und einem zugehörigen Bremselement, das beim vorliegenden Ausführungsbeispiel stangenförmig ausgebildet ist, nämlich ein Metallband 33,34 aus ferromagnetischem Material, das sich längs der X-bzw. Y-Richtung erstreckt. Die Bremsen 28,29 sind im einzelnen in der Figur 3 erkennbar. Das Metallband 33 der X-Bremse 28 ist mittels Befestigungswinkeln 35 an den Seitenwangen 22 befestigt, während das Metallband 34 der Y-Bremse 29 an der Unterseite des Führungsarmes 8 vorzugsweise durch an den freien Enden des Metallbandes 34 angeordnete Schrauben befestigt ist. Die Metallbänder 33,34 bestehen jeweils aus zwei übereinander angeordneten Flachbändern zwischen denen eine Dämmschicht bzw. ein Dämmstreifen aus weichem bzw. zähem oder elastischem Material. Beim vorliegenden Ausführungsbeispiel ist ein doppelseitig klebender Klebestreifen vorzugsweise aus Kunststoff oder Papier angeordnet und vorzugsweise mit den Flachbändern 36 verklebt. Hierdurch werden Vibrationen und die Erzeugung von akustischen Tönen beim Anschlagen der Bremse vermieden.

Da die Metallbänder 33,34 in ihrer Längsrichtung unnachgiebig sind bzw. unnachgiebig gehalten sind, führt jeweils eine Betätigung der Bremse 28,29, durch Schließen eines nicht dargestellten elektrischen Kreislaufs, in dem der zugehörige Elektromagnet 31,32 angeordnet ist, zu einer exakten Fixierung des Führungsarms 8 bzw. des Bestückungskopfes 12 in der jeweiligen Bewegungsrichtung. Von Bedeutung ist auch, daß die Elektromagneten 31,32 jeweils an der unteren Seite des zugehörigen Metallbandes 33,34 angeordnet sind, wodurch auf Verschmutzungen beruhende Funktionsstörungen der Bremsen 28,29 verhindert sind. Beim vorliegenden Ausführungsbeispiel ist der Elektromagnet 31 der X-Bremse 28 auf der Führungsplatte 23 angeordnet, während der Elektromagnet 32 der Y-Bremse 29 unterhalb des Führungsarmes 8 auf einem letzteren untergreifenden U-Bügel 38 angeordnet ist, der an der Unterseite der Führungsplatte 23 durch Schrauben befestigt ist.

Das durch die Saugnadel 18 gebildete Bestückungs-Werkzeug ist in der allgemein mit 19 bezeichneten senkrechten Z-Führung durch ein senkrechtes Verschieben des Bestückungskopfes 12 verschiebbar. Außerdem ist die Saugnadel 18 im Bestückungskopf 12 in einer mit 39 bezeichneten senkrechten Führung um vorzugsweise nur einige Millimeter verschiebbar, was durch den Doppelpfeil Z₁ verdeutlicht ist.

Beide senkrechte Führungen 19,39 sind Wälzlagerführungen und somit von hoher Präzision. Die Z-Führung 19 weist eine senkrechte runde Führungsstange 43 auf, die mit einem Wälzlagerkäfig in einem am Führungsarm 8 befestigten senkrechten Führungsstücke 44 verschiebbar ist. Zwecks Vermeidung einer horizontalen Verdrehung des Bestückungskopfes 12 um die Führungsstange 43 ist eine zweite senkrechte Führungsstange 45 im kastenförmigen Gehäuse 46 des Bestückungskopfes 12 angeordnet, die von einem seitlichen Ansatz 47 des Führungsstückes 44 ebenfalls mit Präzision gabelförmig umgriffen wird. Mittels einer zwischen dem Führungsstück 44 oder Anbauteilen und dem Gehäuse 46 wirksamen Blattfeder 48 wird der Bestückungskopf 12 in seine obere Endstellung beaufschlagt.

Der in figur 5 dargestellten senkrechten Führung 19 ist ebenfalls eine allgemein mit 51 bezeichnete Bremse zugeordnet, die ebenfalls eine an einen nicht dargestellten Stromkreislauf angeschlossene Elektromagnetbremse mit einem Elektromagneten 52 und einer Bremsfläche aus ferromagnetischem Material, die beim vorliegenden Ausführungsbeispiel ebenfalls an einem Metallband angeordnet ist, das längs des Elektromagneten 52 beweglich gehalten ist, so daß letzterer unbeweglich angeordnet werden kann. Beim vorliegenden Ausführungsbeispiel ist der Elektromagnet 52 an einem Halter 54 befestigt, der am vom Führungsstück 44 ausgehenden Ansatz 47 befestigt ist. Das Metallband ist ein Plättchen 53, das in senkrechter Position mittels einer an ihm befestigten Blattfeder 55 an der Seitenwand 56 des Gehäuses 46 so befestigt ist, daß es längs des Elektromagneten 52 auslenkbar ist, um bei Beaufschlagung des Elektromagneten 52 spaltfrei an dessen Stirnseite anzuliegen. Bei allen Bremsen 28,29,51 ist die Anordnung so getroffen, daß zwischen dem Elektromagneten 31,32,52 und den zugehörigen Metallbändern 33,34 bzw. Plättchen 53 ein kleiner Luftspalt vorhanden ist. Hierdurch werden Schleifgeräusche vermieden, wenn der Bestückungskopf 12 im gelösten Zustand der Bremsen verstellt wird.

Dem durch die Saugnadel 18 gebildeten Bestückungswerkzeug ist ein Schalter 61 (Fig. 6) beim vorliegenden Ausführungsbeispiel an der Oberseite des Bestückungskopfes 12 angeordnet, der nahe der obersten Position der Saugnadel 18 in der mit Z₁ bezeichneten Bewegungsrichtung betätigt wird. Es handelt sich um einen sog. Übersetzungsschalter, um zu erreichen, daß die Schaltung mit einer möglichst kleinen Bewegung der Saugnadel 18 in der Z₁-Bewegungsrichtung erreicht wird. Der Schalter 61 ist ein berührungsloser Schalter mit einem beweglichen Schaltelement 62 und einem stationären Schaltelement 63. Das bewegliche Schaltelement 62 ist in Form eines hier einarmigen Hebels 64 bei 65 vertikal schwenkbar gelagert, das mittels einer Feder, vorzugsweise einer Blattfeder 66, in seine Kontaktstellung mit dem stationären Schaltelement 63 beaufschlagt ist. Die durch Eigengewicht oder durch Federkraft sich normalerweise in ihrer unteren Stellung befindliche Saugnadel 18 drückt mit einem Betätigungsglied 67 normalerweise auf den Hebel 64, wodurch der Schalter 61 geöffnet wird. Sobald die Saugnadel 18 geringfügig angehoben wird, wird der Schalter 61 mittels der Blattfeder 66 geschlossen. Da der Abstand a der Saugnadel 18 vom Lagerpunkt 65 des Hebels 64 viel kleiner ist als die Länge 1 des Hebels 64, vorzugsweise etwa nur 1/5 der Länge 1 beträgt, genügt schon eine geringe senkrechte Bewegung der Saugnadel 18, um den berührungslosen Schalter 61 zu betätigen.

Dem Bestückungskopf 12 ist im Bereich der Z-Führung 19 ein zweiter, andeutungsweise dargestellter Schalter 71, Fig. 4 zugeordnet, der in einem Bereich zwischen der untersten und der obersten Position des Bestückungskopfes 12 (vorzugsweise im mittleren Bereich) zwischen diesen Positionen, die Funktion der Bremsen 28,29,51 unterbindet. Dieser Schalter wird durch zwei relativ zueinander verstellten Führungsstück der Z-Führung, hier durch das Gehäuse 46, an dem der Schalter 71 befestigt ist, und das Führungsstück 44 betätigt.

Das Magazin 14 umfaßt eine Magazinstange 81 in Form einer Profilschiene mit einer Mehrzahl von Magazinkästen 82, die - da das vorliegende Gerät zum Bestücken von kleinen SMD-Bauelementen 15 bestimmt ist - verhältnismäßig klein ausgebildet sind. Es handelt sich um mittels eines Deckels, vorzugsweise eines Klappdeckels 83, wahlweise zu öffnende und zu schließende Magazinkästen 82, die nur für den kurzen Zeitabschnitt der Bestückung geöffnet werden. Hierdurch wird vermieden, daß Bauelemente 15 unabsichtlich in falsche Magazinkästen 82 geraten, wodurch hierdurch hervorgerufene Fehlbestückungen ausgeschlossen werden.

Das Magazin 14 ist in der Nähe des Halterahmens 3 für die Leiterplatten 4 angeordnet, um lange Transportwege für die Bauelemente 15 zwischen dem Magazin 14 und der Leiterplatte 4 möglichst zu vermeiden. Beim vorliegenden Ausführungsbeispiel befindet sich das Magazin 14 links neben dem Halterahmen 3. Es könnte jedoch auch rechts neben und/oder vor bzw. hinter dem Halterahmen 3 angeordnet sein.

Zur Halterung des Magazins 14, hier der Magazinstange 81, ist ein Magazinhalter 84 am Gestell 17 angeordnet, der in vergleichbarer Weise wie der Halterahmen 3 zwei horizontale Halteleisten 85 aufweist, von denen eine vorzugsweise entweder in Form einer Klemmleiste 86 ausgebildet ist oder eine solche aufweist. Zwischen den Halteleisten 85 ist die Magazinstange 81 eingesetzt und mittels der Klemmleiste 85 nachgiebig gehalten. Die Anordnung ist so getroffen, daß der Boden 87 der Magazinkästen 82 sich etwa in Höhe der gehaltenen Leiterplatte 4 befindet.

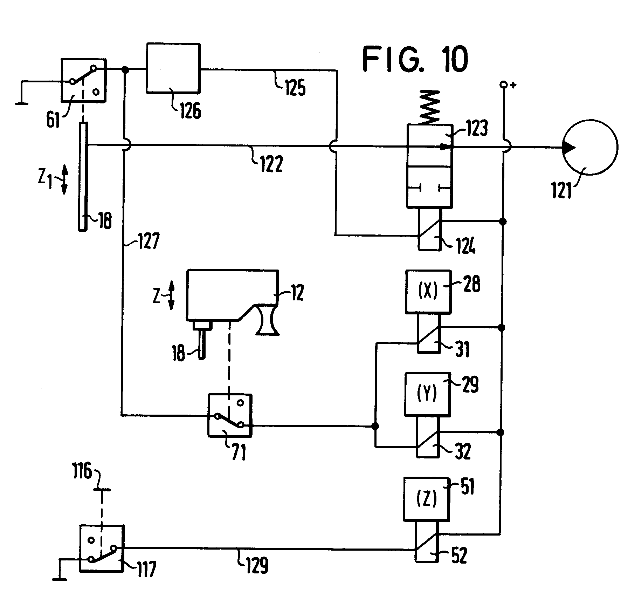

Der in Figuren 7 um 8 dargestellte, sich jeweils an der Oberseite des zugehörigen Magazinkastens 82 befindliche Klappdeckel 83 ist auf der der Leiterplatte 4 abgewandten Seite des Magazinkastens 82 um ein im wesentlichen horizontales Gelenk 88 schwenkbar gelagert, wobei er auf der der Leiterplatte 4 zugewandten Seite einen Verschlußmechanismus, vorzugsweise in Form eines Rastverschlusses 89 aufweist. Dieser Rastverschluß 89 ist manuell, vorzugsweise mit Hilfe des Bestückungswerkzeugs, hier der Saugnadel 18, zu öffnen. Der Rastverschluß 89 weist eine Verrastungsnase 91 auf, die beim vorliegenden Ausführungsbeispiel an einem sich im wesentlichen vertikal erstreckenden Verrastungsarm 92 angeordnet ist, der durch seitliches Wegdrücken aus seiner Verrastungsstellung verstellbar ist und durch Federkraft oder vorzugsweise elastisch in seine Verrastungsstellung zurückgestellt wird, in der er mit seiner Verrastungsnase 91 eine Verrastungskante bzw. -fläche am Klappdeckel 83, hier die Oberseite übergreift. Beim vorliegenden Ausführungsbeispiel weist die Verrastungsnase 91 oberseitig eine Schrägfläche 93 auf, die zur der Leiterplatte 4 abgewandten Seite hin geneigt ist. Der Rastverschluß 89 kann somit mit der Saugnadel 18 entweder durch eine senkrechte Bewegung nach unten oder eine horizontale Bewegung der Saugnadel 18 in Richtung auf die Leiterplatte 4 durch Drücken gegen die Verrastungsnase 91 geöffnet werden, wobei der Klappdeckel 83 nach Lösung der Verrastungsnase 91 automatisch im Sinne eines Sprungdeckels aufspringt.

Um das Öffnen mittels der Saugnadel 18 zu erleichtern, weist der Klappdeckel 83 neben der Verrastungsnase 89 und zwar auf deren der Leiterplatte 4 abgewandten Seite eine Ausnehmung 94 auf, die schmaler bemessen ist, als die Verrastungsnase 91, so daß letztere die Ränder der Ausnehmung 94 zu übergreifen vermag.

Die in Figur 9 dargestellten Magazinkästen 82 bestehen vorzugsweise aus Kunststoff. Beim vorliegenden Ausführungsbeispiel ist der Verrastungsarm 92 einstückig an der zugehörigen Seitenwand des Magazinkastens 82 angeformt und zwar vorzugsweise in Form eines doppelarmigen Hebels, so daß die Verrastungsnase 91 wahlweise durch eine Beaufschlagung des oberen oder unteren Hebelarmes 92.1 zu betätigen ist (Zug- oder Druckbetätigung). Beim vorliegenden Ausführungsbeispiel ist der Verrastungsarm 92 im mittleren Bereich durch Verbindungsstücke 96 mit der Seitenwand 95 verbunden, um die er im Sinne eines Gelenkes 97 mit horizontaler Achse schwenkbar ist. Um die freie Schwenkbarkeit zu gewährleisten, sind innenseitig vom Verrastungshebel seitliche Ausnehmungen 98,99 vorgesehen. Bei dem Magazinkasten 82 handelt es sich um ein Kunststoffspritzteil.

An der Unterseite des Magazinkastens 82 sind krallenförmige Klemmelemente 101 mit Klemmnasen 102 vorgesehen, die seitliche Hinterschneidungen an der Magazinstange 81 hintergreifen. Die Hinterschneidungen sind durch Schrägflächen 103 gebildet, die aufgrund ihrer schrägen Lage ein bequemes Entfernen der Magazinkästen 82 ermöglichen, indem letztere mit einem geringen Kraftaufwand einfach nach oben abgezogen werden, wobei die Klemmelemente 101 nach außen gedrückt werden. Um das Aufklipsen der Magazinkästen 82 auf die Magazinstange 81 ebenfalls zu erleichtern, sind oberseitig der Schrägflächen 103 weitere Schrägflächen 104 dachförmig angeordnet, mittels denen die Klemmelemente 101 beim Aufklipsen auseinandergedrückt werden.

Beim vorliegenden Ausführungsbeispiel sind die Magazinkästen 82 einreihig angeordnet, mittels einer Magazinstange 81. Es ist auch möglich, die Magazinkästen 82 bzw. -stangen zwei- oder mehrreihig anzuordnen, wobei eine entsprechende Anzahl Magazinhalter 84 vorgesehen werden müßten.

Zum Bestücken einer Leiterplatte 4 ist diese im Halterahmen 3 zu haltern. Der Halterahmen 3 weist hierzu zwei weitere, sich quer zur Bedienungsseite 5 erstreckende Halteleisten 85 auf, von denen die linke Halteleiste 111 starr und die rechte Halteleiste 85 in einer sich parallel zur Bedienungsseite 5 erstreckenden Führung bzw. auf einer diese Führung bildenden Führungsschiene 113 verschiebbar und mittels einer Feststellschraube 115 wahlweise feststellbar ist. Die oberen Ränder der Halteleisten 85 sind einander spiegelbildlich gestuft, so daß sich Auflager für die Leiterplatte 4 und letztere seitliche übergreifende Begrenzungsstege ergeben.

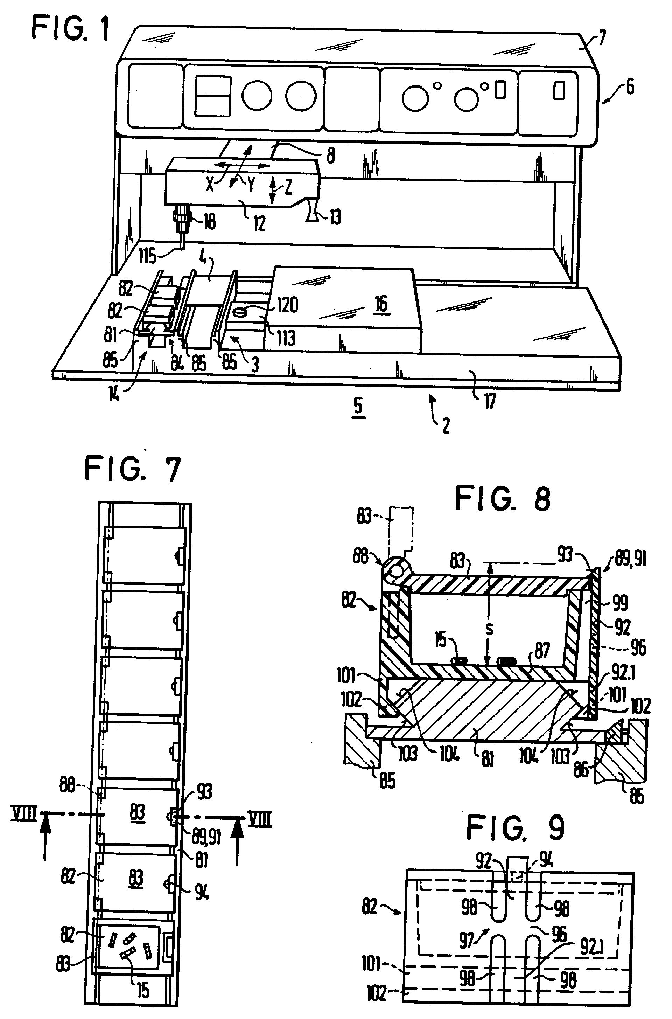

Beim vorliegenden Ausführungsbeispiel ist das Bestückungswerkzeug am Bestückungskopf 12 eine Saugnadel, mittels der ein Bauelement 15 aus dem Magazin 14 entnommen und auf der Leiterplatte 4 an der vorbestimmten Stelle abgesetzt wird. Hierzu ist nach dem Einschalten einer nicht dargestellten Luft-Saugpumpe, die durch eine Schlauchleitung mit der Saugnadel 18 verbunden ist, die Saugnadel zu einem das vorbestimmte Bauelement 15 enthaltenden Magazinkasten 82 zu führen, von denen in Figur 1 aus Vereinfachungsgründen nur zwei Stück dargestellt sind. Die Bewegung der Saugnadel 18 erfolgt dabei durch wahlweises Verschieben des Bestückungskopfes 12 in den drei schon beschriebenen Bewegungsrichtungen X,Y und Z. Das Öffnen des vorbestimmten Magazinkastens 82 erfolgt mittels der Saugnadel 18, wozu letztere entweder von oben nach unten gegen die Schrägfläche 93 oder von der Seite her gegen die Verrastungsnase 91 bzw. den Verrastungsarm 92 zu verschieben ist. Sobald die Verrastung aufgehoben ist, springt der betreffende Klappdeckel 83 auf und die Saugnadel 18 kann in den geöffneten Magazinkasten 82 abgesenkt werden, um ein Bauelement 15 mittels der Saugluft an der Saugspitze 115 der Saugnadel aufzunehmen. Dann wird die Saugnadel über die Leiterplatte 4 gefahren und durch Verschieben nach unten des Bestückungskopfes 12 an der bestimmten Bestückungsstelle aufgesetzt. Sobald das Bauelement 15 auf die Leiterplatte 4 aufgesetzt wird, ergibt sich durch weiteres, geringes Verschieben des Bestückungskopfes 12 nach unten eine Relativverschiebung zwischen der Saugnadel 18 und dem Bestückungskopf 12, wobei letzterer gegenüber ersterer nach unten verschoben wird. Bei dieser Bewegung wird das Schaltelement 62 durch die Saugnadel 18 nach oben verstellt, wodurch der Schalter 61 geschlossen wird, der die Bremsen 28,29 in Funktion setzt und die Saugluft an der Saugspitze 115 abstellt. Aufgrund der Betätigung der Bremsen 28,29 ist die Saugnadel 18 in der horizontalen Ebene fixiert, so daß ein seitliches Verstellen oder Verrutschen aus dieser Bestückungsposition nicht mehr möglich ist.

Durch Betätigung eines kippbaren Schaltgliedes 116 eines Schalters 117, der beim vorliegenden Ausführungsbeispiel ebenfalls an der Oberseite des Bestückungskopfes 12 angeordnet ist und zwar oberhalb der Saugnadel 18, läßt sich auch die dritte Bremse 51 einschalten, wodurch die Saugnadel 18 in allen Bewegungsrichtungen X,Y,Z arretiert ist. In dieser Position übt die Saugnadel eine Haltefunktion auf das zwischen ihrer Spitze und der Leiterplatte 4 befindlichen Bauelement 15 aus. Dies ist insbesondere in solchen Fällen vorteilhaft, in denen das Bauelement durch eine weitere manuelle Handhabung an der Leiterplatte 4 befestigt werden soll, wie insbesondere Löten und Verkleben. Aufgrund der Arretierung der Saugnadel 18 auch in der senkrechten Z-Bewegungsrichtung braucht der Bestückungskopf 12 nicht mehr von Hand gehalten zu werden und die Bedienungsperson hat deshalb beide Hände frei, um z.B. mit der einen Hand das Lötzinn und mit der anderen Hand einen Lötkolben zu führen.

Durch erneute manuelle Betätigung des Schaltgliedes 116 kann der Schalter 117 und somit auch die in der senkrechten Z-Bewegungsrichtung wirksame Bremse 51 ausgeschaltet werden, wonach der Bestückungskopf hochgeschoben werden kann, bzw. durch die Kraft der Blattfeder 66 hochgeschoben wird. Gleichzeitig, d.h. bei der dabei erfolgenden Relativbewegung zwischen dem Bestückungskopf 12 und der Saugnadel 18 wird die Betätigung des Schalters 61 aufgehoben und somit werden auch die Bremsen, 28,29 gelöst, so daß ein neuer Bestückungs- bzw. Reparaturvorgang erfolgen kann. Die Saugluftschaltung zur Aufnahme eines Bauelementes von der Leiterplatte 4 (Reparatur) oder eines nächsten Bauelementes 15 aus dem Magazin 14 erfolgt automatisch durch leichtes Drücken der Saugnadel 18 gegen das Bauelement, wodurch der Schalter 61 betätigt wird und die Saugluft einschaltet.

Beim Öffnen des Deckels 83 wird die Saugnadel 18 in der Regel eingeschoben und der Schalter 61 betätigt. Um hier das Einschalten der Bremsen 28,29 zu verhindern, ist der dies gewährleistende Schalter 71 an die durch die Magazinkastenhöhe vorgegebene Stufe S (Fig. 8) anzupassen. Das heißt, beim vorliegenden Ausführungsbeispiel ist die Einschaltung der Bremsen 28,29 und die Abschaltung der Saugluft nur bei betätigtem Schalter 71, d.h. im unteren Bereich der Z-Bewegung, möglich.

Wie aus den Figuren 2,4 und 6 zu entnehmen ist, kann die Saugnadel 18 und somit auch das von ihr getragene Bauelement 15 um die Längsachse der Saugnadel 18 wahlweise gedreht werden. Hierzu ist sowohl die Saugnadel 18 und auch der Griff 13 um seine vertikale Achse drehbar im Bestückungskopf gelagert, wobei zwischen den oberen Enden der Saugnadel 18 und der den Bestückungskopf 12 durchfassenden Welle des Griffs 13 ein Drehantrieb, vorzugsweise ein Riementrieb, mit Riemenscheiben 118 und einem Riemen 119, vorzugsweise ein Zahnriemen, zugeordnet ist.

Wie der Schaltplan gemäß Figur 10 zeigt, ist in der von einer Vakuumquelle 121 zur Saugnadel 18 führenden Saugleitung 122 ein elektromagnetisch betätigbares Absperrventil 123 angeordnet, dessen Elektromagnet 124 durch eine elektrische Leitung 125 mit dem Schalter 61 verbunden ist, wobei in der Leitung 125 - je nach Ausführung des Schaltkreises als einfacher elektrischer Schaltkreis oder als elektronischer Schaltkreis ein Wechselschalter 120 oder ein Flip-Flop angeordnet ist. Hierdurch wird bei einander nachfolgenden Betätigungen des Schalters 61 der Wechselschalter 126 wechselweise umgeschaltet, so daß die Saugluft wechselweise zu- und abgeschaltet wird. Zwischen den Schaltern 61 und 126 zweigt eine elektrische Leitung 127 ab, in der der Schalter 71 angeordnet ist, und in deren weiteren Verlauf die Elektromagneten 31 und 32 der Bremsen 28 und 29 in Parallelschaltung angeordnet sind. Der Schaltplan zeigt die Saugnadel 18 in angehobener Position (Hauptschalter 61 ist geschlossen) und den Bestückungskopf 12 in herabgesenkter Position, so daß das Schließen der Bremsen 28,29 möglich ist. In der angehobenen Position des Bestückungskopfes 12 ist ein Schließen der Bremsen 28,29 wunschgemäß nicht möglich. Das Schließen und Öffnen der Bremsen 28 und 29 ist somit abhängig in erster Abhängigkeit vom Schalter 71 und zweiter Abhängigkeit vom Schalter 61 und unabhängig von der Stellung des Wechselventils 126. Dagegen kann die in der vertikalen Z-Bewegungsrichtung wirksame Bremse 51 unabhängig von den vorbeschriebenen Betriebszuständen durch manuelle Betätigung des Schalters 117 wahlweise geschlossen und geöffnet werden. Der Elektromagnet 52 der Bremse 51 ist in einer vom Schalter 117 führenden elektrischen Leitung 129 angeordnet.

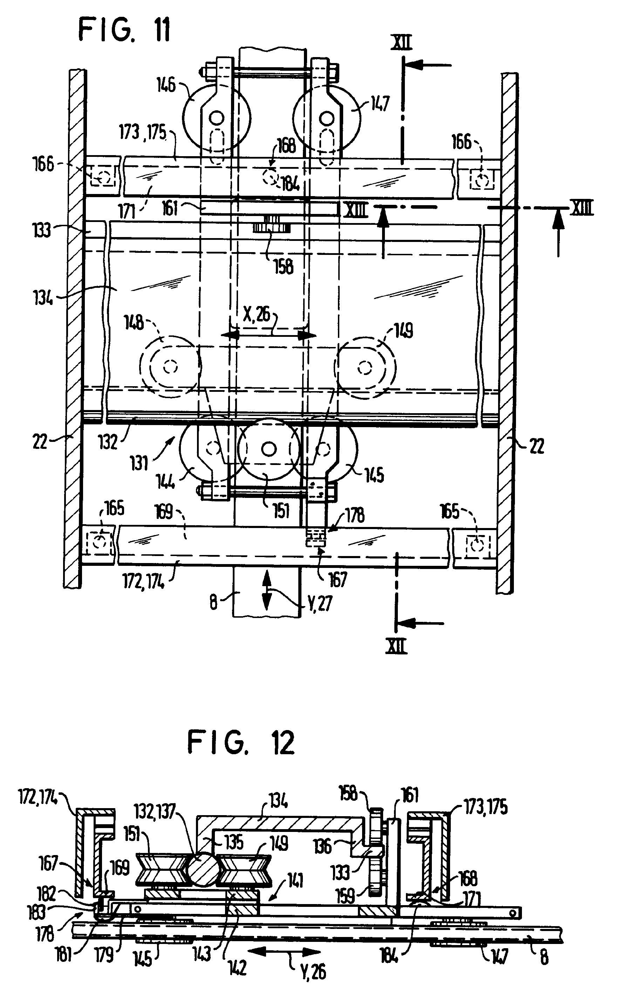

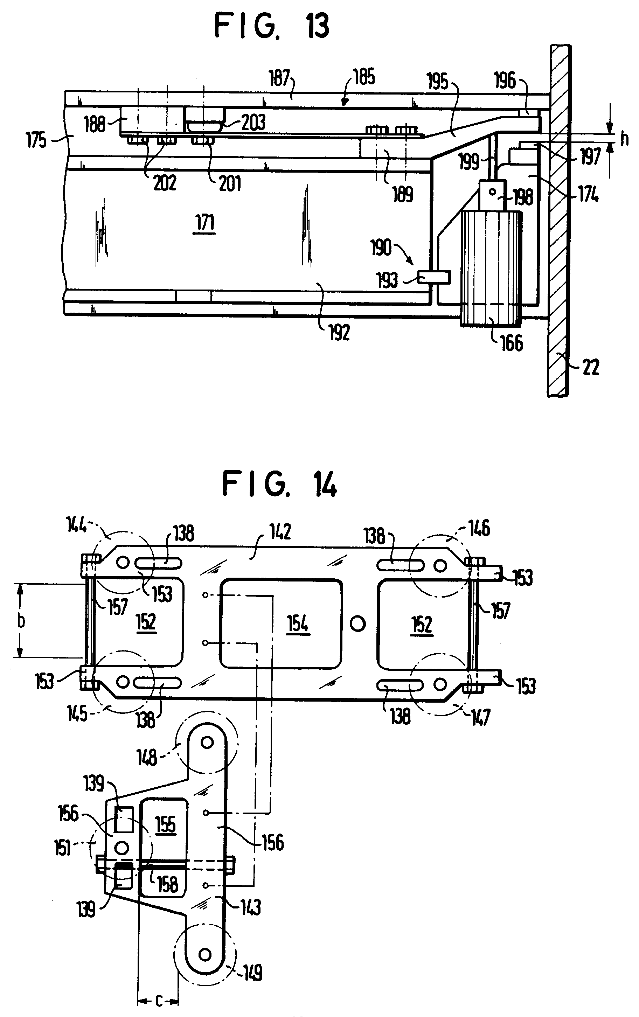

Beim Ausführungsbeispiel nach den Figuren 11 und 12 weist die allgemein mit 131 bezeichnete Kreuzführung zur Führung des Bestückungskopfes 12 bzw. dessen Führungsarm 8 in der X-Richtung eine Haupt-Führungsschiene 132 und eine Hilfs-Führungsschiene 133 auf, die sich horizontal und parallel zur Bedienungsseite 5 des Gerätes 2 in einem Abstand voneinander zwischen den Seitenwangen 22 erstrecken und in nicht dargestellte Weise daran befestigt sind. Die Führungsschienen 132, 133 sind an einem gemeinsamen, sich ebenfalls zwischen den Seitenwangen 25 erstreckenden Führungsprofil 134 angeordnet, dessen abwärts gerichtete Profilschenkel 135, 136 die Führungsschienen 132, 133 tragen. Die Haupt-Führungsschiene 132 ist eine Rundstange 137, die in einer Keilnut an der Unterseite des vorderen vertikalen Schenkels 135 anliegt und daran verschraubt ist. Die Hilfs-Führungsschiene 133 ist durch einen vom hinteren Profilschenkel 136 horizontal nach hinten vorspringenden Profilschenkel gebildet. Der die Führungsrollen tragende Kreuzschlitten 141 ist zweiteilig ausgeführt mit einer unteren im wesentlichen H-förmigen Schlittenplatte 142, die 4 Führungsrollen 144 bis 147 lagert, die den Führungsarm 8 mit V-förmigen Umfangsnuten umgreifen und in der Y-Richtung führen, und eine auf der Schlittenplatte 147 angeordnete rahmenförmige Schlittenplatte 143, die drei Führungsrollen 148 bis 151 trägt, die die Rundstange 137 mit ebenfalls V-förmigen Umfangsnuten umgreifen und auf von der Schlittenplatte 143 nach oben weisenden Achsen frei drehbar gelagert sind, wobei die auf der einen Seite der Rundstange 137 angeordnete Führungsrolle 151 mittig zu den anderen beiden Führungsrollen 148, 149 angeordnet ist. Aufgrund von Aussschnitten 152 und Längslöchern 138 in den Schenkeln 153 der Schlittenplatte 142 sowie einem mittigen Ausschnitt 154 und Längslöchern 150 in einem Stegteil der Schlittenplatte 142 und aufgrund der Ausparung 155 in der rahmenförmigen Schlittenplatte 143 sowie zu beiden Seiten der Achse der Führungsrolle 151 vorhandenen Längslöchern 139 können die Führungsabstände b, c mittels ein an der gegenüberliegende Schenkel 153 der Schlittenplatte 142 und ein der gegenüberliegende Rahmenstege 156 der Schlittenplatte 143 miteinander verbindende Spannschrauben 157, 158 eingestellt werden. Außerdem wird das Gewicht und die Masse der Schlittenplatten 142,143 stark verringert. In Fig. 14 sind die Schlittenplatten 142, 143 als Einzelteile in demontierter Stellung dargestellt.

Die Hilfs-Führungsschiene 133 erstreckt sich zwischen zwei übereinander angeordneten Führungsrollen 158, 159, die mittels horizontalen, quer zur Führungsschiene 133 Achsen an einem aufrechten Lagerschenkel 161 gelagert sind, der auf der Schlittenplatte 142 befestigt ist.

Die vorbeschriebene Führung in der X-Richtung weist eine zufriedenstellende Stabilität auf. Es ist nicht wie beim ersten Ausführungsbeispiel möglich, die Führungsschienen 132, 133 auseinanderzudrücken, wodurch die Führung wesentlich beeinträchtigt wird. Darüber hinaus trägt das Führungsprofil 134 zur Stabilisierung der Seitenwangen 22 in Kastenbauweise bei.

Bei der Ausgestaltung insbesondere gemäß Figuren 2 und 3 sind die Bremsen 28, 29 Bestandteile der Führungsplatte 23. Hierdurch wird die Handhabung des Bestückungskopfes 12 durch die Massenträgheit der Elektromagnete 31, 32 wesentlich erschwert. Außerdem sind zu den Elektromagneten führende Elektroleitungen anzuordnen und ebenfalls zu bewegen, wodurch die Handhabung weiter erschwert wird.

Beim Ausführungsbeispiel gemäß Figuren 11 bis 14, sind die Elektromagnete 165, 166 der mit 167, 168 bezeichneten Bremsen für die X- und Y-Bewegungsrichtung des Bestückungskopfes 12 von den bewegbaren Teilen der Kreuzführung 131 entfernt und stationär angeordnet. Dies wird durch sich parallel zum Führungsprofil 134 erstreckende Bremsschienen 169, 171 erreicht, von denen die eine den Kreuzschlitten 141 (X-Bewegung) und die andere den Führungsarm 8 (Y-Bewegung) abzubremsen vermag.

Beim Ausführungsbeispiel nach Figuren 11 bis 14 sind die Bremsschienen 169, 171 in sich parallel zum Führungsprofil 134 erstreckender Anordnung vor und hinter letzterem angeordnet, wobei sie jeweils an sich quer zu den Seitenwangen 22 erstreckenden und in nicht dargestellter Weise an den Seitenwangen 22 befestigten Traversen 172, 173 gehalten sind. Die Traversen 172, 173 sind durch Winkelschienen 174, 175 gebildet, deren horizontale Schenkel oberseitig angeordnet sind. Die Bremsschienen 169, 171 sind durch U-Schienen gebildet, deren Schenkel sich horizontal erstrecken, und die mit einer unteren Seitenfläche die Bremsfläche bilden. Wie insbesondere aus Figur 12 deutlich zu entnehmen ist, steht die vordere Bremsschiene 169 dicht oberhalb eines Bremsteils 178, das an einem von der Schlittenplatte 142 horizontal vorspringenden vertikal elastisch ausfederbaren, vorzugsweise doppelarmigen, Bremsarm 179 (Blattfeder) so gelagert ist, daß es in seiner Normalstellung mit einem unterseitig an ihm angeordneten, hartgummiartigen Druckstück 181 sich dicht oberhalb des Führungsarms 8 befindet. Sobald die Bremsschiene 169 abgesenkt wird, wird das Druckstück 181 gegen die Oberseite des Führungsarms 8 gepreßt, wodurch eine Bremsung zwischen dem Kreuzschlitten 141 und dem Führungsarm 8 herbeigeführt wird. Aufgrund der parallelen Erstreckung der Bremsschiene 169 zu den Führungsschienen 132, 133 kann das Bremsteil 178 in jeder Position der X-Bewegung durch die Bremsschiene 169 betätigt werden. Beim vorliegenden Ausführungsbeispiel ist am Bremsteil 168 eine kleine Rolle 182 um eine zur Y-Bewegungsrichtung parallele Achse frei drehbar in einem Gabelkopf 183 gelagert, wodurch beim Bremsen in der X-Bewegungsrichtung wirksame Spannungen und hieraus resultierende Ungenauigkeiten vermieden werden.

Die hinter dem Führungsprofil 134 angeordnete Bremsschiene 171 erstreckt sich ebenfalls parallel zum Führungsprofil 134 und wirkt mit einem Bremsteil 184 zusammen, das ebenfalls ein hartgummiartiges Druckstück ist und auf der unteren Schlittenplatte 142 befestigt ist. Durch diese Bremse 168 werden in X-Richtung gerichtete Bewegungen des Kreuzschlittens 141 abgebremst. Aufgrund der zur X-Richtung parallelen Erstreckung der Bremsschiene 171 ist das Bremsteil 184 ebenfalls in jeder Stellung der X-Bewegung des Kreuzschlittens 141 durch die Bremsschiene 171 betätigbar.

Jede Bremsschiene 169, 171 wird durch zwei an ihren Enden angreifende Elektromagnete 165 oder 166 vertikal verstellt um die Bremsung bzw. deren Lösung herbeizuführen. In Figur 13 ist dies in Verbindung mit einer reibungsarmen vertikalen Führung für die Bremsschiene 171 an ihrem rechten Ende dargestellt. Diese Vertikalführung 185 weist eine sich horizontal erstreckende Blattfeder 186 auf, die mittels an der Unterseite des horizontalen Schenkels 187 der Winkelschiene 175 und an der Oberseite der Bremsschiene 171 durch Schrauben befestigte Lagerböckchen 188, 189 zwischen der Winkelschiene 175 und der Bremsschiene 171 in horizontaler Position gehalten ist. Hierdurch ist das betreffende Ende der Bremsschiene 171 in der horizontalen Ebene bewegungsfrei gehalten, wobei sie aufgrund der leichten Biegbarkeit der Blattfeder 186 vertikal leicht verstellt werden kann. Da die Blattfeder 186 einer Torsion um ihre Längsachse einen geringen Widerstand entgegensetzt, ist am unteren Ende der Bremsschiene 171 eine Seitenführung 190 vorgesehen, die durch eine den Steg 192 der Bremsschiene 171 übergreifende Gabel 193 an einem den zugehörigen Elektromagneten 166 tragenden und am vertikalen Schenkel der Winkelschiene 175 befestigten Lagerteil 194 gebildet ist. Vom Lagerböckchen 189 erstreckt sich ein Anschlagarm 195 zwischen gepolsterte Anschläge 196, 197, für die Vertikalbewegung der Bremsschiene 171. Der Anschlag 196 wird durch ein Dämpfelement am horizontalen Schenkel 187 der Winkelschiene 175 gebildet, während der Anschlag 197 ein Dämpfelement am Lagerteil 174 ist, bei dem es sich um ein Kunststoffteil handelt. Der Zuganker 198 des zugehörigen Elektromagneten 166 ist durch eine Zugstange 199 mit dem Anschlagarm 195 verbunden, der beim vorliegenden Ausführungsbeispiel mit der Zugstange 199 und dem Lagerböckchen 189 ein einstückiges Kunststoffteil bildet. Der nur wenige nun betragende Hub der Bremsschiene 171 ist mit h bezeichnet.

Die vertikale Federkraft der Blattfeder 186 läßt sich einfach und handhabungsfreundlich durch eine Stellschraube 201 einstellen, die auf der dem freien Ende der Blattfeder 186 zugewandten Seite von die Blattfeder 186 an der Winkelschiene 175 fixierenden Befestigungsschrauben 202 angeordnet ist. Vorzugsweise drückt der Kopf der Stellschraube 201 die Blattfeder 186 gegen ein Gummipolster, das in einer Aussparung 203 des Lagerböckchens 188 angeordnet ist. Hierdurch wird ein Vibrieren der Blattfeder 186 verhindert. Die Federkraft wird so groß eingestellt, daß sie die Bremsschiene 171 gegen den oberen Anschlag 196 zieht. Der zugehörige Elektromagnet 166 braucht somit nur Zugarbeit auszuüben, um die Bremsung herbeizuführen, wobei danach die Bremsschiene 171 durch die Blattfeder 186 zurück- bzw. hochgezogen wird. Die Anordnung und Funktion des anderen Endes der Bremsschiene 171 sowie die der anderen Bremsschiene 169 ist entsprechend.

Beim Ausführungsbeispiel gemäß Figuren 11 bis 14 sind die Bremsen 167, 168 bzw. Elektromagneten-Paare 165, 166 jeweils für sich, d.h. separat, durch je einen nicht dargestellten Schalter, wie einen Hand- oder Fußschalter betätigbar. Hierdurch wird gewährleistet, daß die bestückenden Bauelemente wahlweise exakt nur in einer der beiden Koordinatenrichtungen (X, Y) zu auf die Leiterplatte 4 gesetzt werden können. Wahlweise sollen die beiden Bremsen 167, 168 dieses Ausführungsbeispiels und auch die beiden Bremsen 28, 29 des ersten Ausführungsbeispiels durch einen Schalter, insbesondere einen Fußschalter, gemeinsam betätigbar sein und zwar wahlweise unabhängig von einem Berührungskontakt zwischen dem Bauelement 15 und der Leiterplatte 4 bzw. dem Schalter 61 gemäß Figur 10.

## Patentansprüche

1. Gerät (2) zum Bestücken und/oder Verlöten bzw. Verkleben von elektronischen Bauelementen (15), insbesondere SMD-Bauelementen, auf Leiterplatten (4),
mit einem ersten Träger (3) für wenigstens eine Leiterplatte (4),
mit einem zweiten Träger (12, 18) für ein Bauelement (15), wobei einer der Träger (12, 18) parallel zur Ebene der Leiterplatte (4) in zwei quer zueinander verlaufenden Verstellrichtungen (X, Y) verstellbar ist
und einer der Träger (3, 12, 18) quer zur Leiterplatte (3) relativ zum anderen Träger (3) verstellbar ist,
und mit einem Magazin (14) für die Bauelemente (15).
**dadurch gekennzeichnet,**
daß dem parallel zur Ebene der Leiterplatte (4) verstellbaren Träger (12, 18) in einer der beiden Verstellrichtungen (X,Y) oder in beiden Verstellrichtungen (X, Y) jeweils eine Bremse (28, 29; 167, 168) zugeordnet ist, die wahlweise in Funktion setzbar ist oder dann in Funktion setzbar ist, wenn zwischen dem verstellbaren Träger (12, 18), dem Bauelement (15) und der Leiterplatte (4) Berührungskontakt besteht.

2. Gerät (2) zum Bestücken und/oder Verlöten bzw. Verkleben von elektronischen Bauelementen (15), insbesondere SMD-Bauelementen, auf Leiterplatten (4),
mit einem ersten Träger (3) für wenigstens eine Leiterplatte (4),
mit einem zweiten Träger (12, 18) für ein Bauelement (15), wobei einer der Träger (12, 18) parallel zur Ebene der Leiterplatte (4) in zwei quer zueinander verlaufenden Verstellrichtungen (X, Y) verstellbar ist
und einer der Träger (3,12,18) quer zur Leiterplatte (3) relativ zum anderen Träger (3) verstellbar ist,
und mit einem Magazin (14) für die Bauelemente (15), oder Gerät nach Anspruch 1,
**dadurch gekennzeichnet**,
daß dem quer zur Ebene der Leiterplatte (4) verstellbaren Träger (12, 18) in seiner quer zur Ebene der Leiterplatte (4) verlaufenden Verstellrichtung (Z) eine Bremse (51) zugeordnet ist, die wahlweise in Funktion setzbar ist oder in einer Position in Funktion setzbar ist, in der zwischen diesem verstellbaren Träger (12, 18), dem Bauelement (15) und der Leiterplatte (4) Berührungskontakt besteht.

3. Gerät nach Anspruch 1 oder 2,
dadurch gekennzeichnet,
daß die jeweilige Bremse (28, 29; 167, 168) oder beide Bremsen (28,29; 167, 168) jeweils separat oder gemeinsam durch die Betätigung eines Schalters, insbesondere eines Hand- oder Fußschalters in Funktion setzbar ist bzw. sind.

4. Gerät nach Anspruch 1 oder bis 3, dadurch gekennzeichnet, daß der zweite Träger (12,18) für das Bauelement (15) in den parallel zur Ebene der Leiterplatte (4) verlaufenden Verstellrichtungen (X,Y) und vorzugsweise auch in der quer zur Ebene der Leiterplatte (4) verlaufenden Verstellrichtung (Z) verstellbar ist.

5. Gerät nach einem der Ansprüche 1 bis 4, dadurch gekennzeichnet, daß der verstellbare Träger (12,18) quer zur Ebene der Leiterplatte (4) teleskopierbar ist und wenigstens eine der in den parallel zur Ebene der Leiterplatte (4) verlaufenden Verstellrichtungen (X,Y) wirksame Bremse (28,29) bei einer Relativverschiebung der Teleskopteile (8,12) in Funktion gesetzt wird.

6. Gerät nach einem der Ansprüche 1 bis 5, wobei der verstellbare Träger (12,18) an einem Führungsarm (8) angeordnet ist, der mittels eines Kreuzkopfes (9) in einer Kreuzführung (9) parallel zu der Ebene der Leiterplatte verstellbar ist, dadurch gekennzeichnet, daß die in der parallel zur Ebene der Leiterplatten (4) wirksamen Bremsen (28,29) im Bereich des Kreuzkopfes (23) angeordnet sind.

7. Gerät nach Anspruch 6, dadurch gekennzeichnet, daß die in der längs des Führungsarmes (8) verlaufenden Verstellrichtung (Y) wirksame Bremse (29) zwischen dem Kreuzkopf (23) und dem Führungsarm (8) wirksam ist.

8. Gerät nach einem der Ansprüche 1 bis 7, dadurch gekennzeichnet, daß der zweite Träger ein Bestückungskopf (12) mit einem Gehäuse (46) ist, der an einem parallel zur Ebene der Leiterplatte (4) verstellbaren Führungsarm (8) in einer vertikalen Führung (39) verstellbar ist, dadurch gekennzeichnet, daß die in der quer zur Ebene der Leiterplatte (4) verlaufenden Verstellrichtung (Z) wirksame Bremse (51) im Gehäuse (46) angeordnet ist.

9. Gerät nach einem der Ansprüche 1 bis 8, dadurch gekennzeichnet, daß die Bremse (28,29,51) jeweils durch einen mit einer ferromagnetischen Fläche zusammenwirkenden Elektromagneten (31) gebildet ist.

10. Gerät nach einem der Ansprüche 5 bis 9, dadurch gekennzeichnet, daß die Relativverschiebung zwischen den Teleskopteilen (18,46) des zweiten Trägers (12) durch einen elektrischen Schalter (61) ermittelt wird, der den Elektromagneten (31) beschaltet.

11. Gerät nach einem der Ansprüche 1 bis 10, dadurch gekennzeichnet, daß die in der quer zur Ebene der Leiterplatte (4) verlaufenden Verstellrichtung (Z) wirksame Bremse (51) durch einen elektrischen Schalter (117) in Funktion setzbar ist.

12. Gerät nach einem der Ansprüche 9 bis 11, dadurch gekennzeichnet, daß die ferromagnetische Fläche an einem band- oder stangenförmigen Bremselement (33,34,53) ausgebildet ist.

13. Gerät nach Anspruch 12, dadurch gekennzeichnet, daß der Elektromagnet (31) unterhalb des band- oder stangenförmigen Bremselementes (33,34,53) angeordnet ist.

14. Gerät nach Anspruch 12 oder 13, dadurch gekennzeichnet, daß das band- oder stangenförmige Bremselement (33,34,53) nur an einem Ende oder nur an beiden Enden an einem Tragteil (22,8) befestigt ist.

15. Gerät nach Anspruch 14, dadurch gekennzeichnet, daß das Bremselement (33) parallel zur Ebene der Leiterplatte (4) frei hängend befestigt ist.

16. Gerät nach einem der Ansprüche 12 bis 15, dadurch gekennzeichnet, daß das Bremselement aus zwei Flachbändern (36) besteht, zwischen denen ein Dämmstreifen (37) aus weichem, bzw. elastischem Material angeordnet ist.

17. Gerät nach einem der Ansprüche 12 bis 16, dadurch gekennzeichnet, daß das Bremselement ein plattenförmiges Bauteil (53) ist, das durch eine sich parallel zu diesem Bauteil erstreckende Blattfeder (55) mit seinem Tragteil (46) verbunden ist.

18. Gerät nach einem der Ansprüche 1 bis 17, dadurch gekennzeichnet, daß der Boden (87) des Magazins (14) im wesentlichen in der Ebene der Leiterplatte (4) angeordnet ist.

19. Gerät nach einem der Ansprüche 1 bis 18,
dadurch gekennzeichnet,
daß wenigstens die in der Ebene der Leiterplatte (4) wirksamen Bremsen (167, 168) sich jeweils parallel zum zugehörigen Verstellrichtung (X,Y) erstreckende, quer zur Ebene der Verstellrichtungen (X,Y) bewegbare Bremsschienen (169, 171) aufweisen, von denen jede gegen das zugehörige in der betreffenden Verstellrichtung (X, Y) bewegbare Führungsteil (8,141, 142) verstellbar ist.

20. Gerät nach Anspruch 19, dadurch gekennzeichnet, daß zwischen den zueinander gehörigen Bremsschienen (169, 171) und Führungsteilen (8,141, 142) Bremselemente (181, 184), vorzugsweise aus Hartgummi oder dergleichen angeordnet sind.

21. Gerät nach Anspruch 20, wobei der verstellbare Träger (12,18) an einem Führungsarm (8) angeordnet ist, der mittels eines Kreuzkopfes (141) in einer Kreuzführung (131) parallel zu der Ebene der Leiterplatte (4) verstellbar ist, dadurch gekennzeichnet, daß das mit dem Führungsarm (8) zusammenwirkende Bremselement (181) an einem Arm (179) angeordnet ist, der vertikal flexibel mit dem kreuzkopf (141) verbunden ist.

22. Gerät nach einem der Ansprüche 19 bis 21, dadurch gekennzeichnet, daß die Bremsschienen (169, 171) an sich quer zwischen den Seitenwänden (22) des Gerätes (2) angeordneten Traversen (172, 173) vertikal bewegbar gehalten sind.

23. Gerät nach einem der Ansprüche 20 bis 22, dadurch gekennzeichnet, daß die Bremsschienen (169,171) durch jeweils an beiden Enden angeordnete Elektromagnete (165, 166) bewegbar sind.

24. Gerät nach einem der Ansprüche 1 bis 23, wobei der verstellbare Träger (12, 18) an einem Führungsarm (8) angeordnet ist, der mittels eines Kreuzkopfes (141) in einer Kreuzführung (131) parallel zu der Ebene der Leiterplatte (4) verstellbar ist, dadurch gekennzeichnet, daß zur Führung des Kreuzkopfes (141) eine Haupt-Führungsschiene (132) in Form einer Stange (137) mit zwei quer zueinander gerichteten Führungsebenen, und eine Hilfs-Führungsschiene (133) mit nur einer Führungsebene vorgesehen sind, die sich im wesentlichen parallel zu einer die Führungsschienen (132, 133) längs schneidenden Ebene erstreckt.

25. Gerät nach Anspruch 24, dadurch gekennzeichnet, daß die beiden Führungsschienen (132,133) starr miteinander verbunden sind.

26. Gerät nach einem der Ansprüche 1 bis 24, dadurch gekennzeichnet, daß Rollen-Paare (144 bis 151) zur Führung an den Führungsschienen (133, 137) vorgesehen sind, von denen wenigstens einige Rollen an quer biegbaren und vorzugsweise durch Anschnitte (138,139,155) geschwächten Schenkeln (153) oder Stegen (156) gelagert sind, und daß der Führungsabstand (b,c) der Rollen durch die Schenkel oder Stege quer verspannende Spannschrauben (157, 158) einstellbar ist.

## Claims

1. An apparatus (2) for mounting and/or soldering or cementing electronic components (15), in particular SMD components, on printed circuit boards (4), having a first carrier (3) for at least one circuit board (4), having a second carrier (12, 18) for a component (15), one of the carriers (12, 18) being displaceable parallel to the plane of the circuit board (4) in two mutually transverse displacement directions (X, Y), and one of the carriers (3, 12, 18) being displaceable relative to the other carrier (3) transversely of the circuit board (3), and having a magazine (14) for the components (15),
characterised in that,
the carrier (12, 18) displaceable parallel to the plane of the printed circuit board (4) has associated with it, for one of the two directions of displacement (X, Y) or for both directions of displacement (X, Y), a brake or respective brakes (28, 29; 167, 168) which can be operated as desired or can be operated when there is physical contact between the displaceable carrier (12, 18), the component (15) and the printed circuit board (4).

2. An apparatus (2) for mounting and/or soldering or cementing electronic components (15), in particular SMD components, on printed circuit boards (4), having a first carrier (3) for at least one circuit board (4), having a second carrier (12, 18) for a component (15), one of the carriers (12, 18) being displaceable parallel to the plane of the circuit board (4) in two mutually transverse displacement directions (X, Y), and one of the carriers (3, 12, 18) being displaceable relative to the other carrier (3) transversely of the circuit board (3), and having a magazine (14) for the components (15), or an apparatus according to claim 1,
characterised in that
the carrier (12, 18) displaceable transversely to the plane of the printed circuit board (4) has associated with it, for its displacement direction (Z) transverse to the plane of the printed circuit board (4), a brake (51) which can be operated as desired or can be operated in a position in which there is physical contact between the displaceable carrier (12, 18), the component (15) and the printed circuit board (4).

3. An apparatus according to claim 1 or 2,
characterised in that,
the respective brake (28, 29; 167, 168) or both brakes (28, 29; 167, 168) can be operated separately or together by operating a switch, in particular a hand or foot switch.

4. An apparatus according to any of claims 1 to 3,
characterised in that,
the second carrier (12, 18) for the component (15) is displaceable in the directions of displacement (X, Y) extending parallel to the plane of the printed circuit board (4) and preferably also in the direction of displacement (Z) extending transversely to the plane of the printed circuit board (4).

5. An apparatus according to any of claims 1 to 4, characterised in that, the displaceable carrier (12, 18) is telescopic transversely to the plane of the printed circuit board (4) and at least one of the brakes (28, 29) effective in the directions of displacement (X, Y) extending parallel to the plane of the printed circuit board (4) is operated by relative displacement of the telescopic parts (8, 12).

6. An apparatus according to any of claims 1 to 5, the displaceable carrier (12, 18) being arranged on a guide arm (8) which can be displaced parallel to the plane of the printed circuit board (4) by means of a crosshead (9) in a cross guide (9), characterised in that the brakes (28, 29) effective in parallel to the plane of the printed circuit board (4) are arranged in the region of the crosshead (23).

7. An apparatus according to claim 6, characterised in that the brake (29) effective in the direction of displacement (Y) extending along the guide arm (8) acts between the crosshead (23) and the guide arm (8).

8. An apparatus according to any of claims 1 to 7, characterised in that the second carrier is a mounting head (12) with a housing (46) which can be displaced on a guide arm (8) displaceable parallel to the plane of the printed circuit board (4) in a vertical guide (39), characterised in that the brake (51) effective in the direction of displacement (Z) extending transverse to the plane of the printed circuit board (4) is arranged in the housing (46).

9. An apparatus according to any of claims 1 to 8, characterised in that the brake (28, 29, 51) in each case comprises an electromagnet (31) cooperating with a ferromagnetic surface.

10. An apparatus according to any of claims 5 to 9, characterised in that the relative displacement between the telescopic parts (18, 46) of the second carrier (12) is detected by an electric switch (61) which operates the electromagnets (31).

11. An apparatus according to any of claims 1 to 10, characterised in that the brake (51) effective in the direction of displacement (Z) extending transverse to the plane of the printed circuit board (4) can be operated by an electric switch (117).

12. An apparatus according to any of claims 9 to 11, characterised in that the ferromagnetic surface is formed on a strip or rod-shaped brake element (33, 34, 53).

13. An apparatus according to claim 12, characterised in that the electromagnet (31) is arranged underneath the strip or rod-shaped brake element (33, 34, 53).

14. An apparatus according to claim 12 or 13, characterised in that the strip or rod-shaped brake element (33, 34, 53) is attached only at one end or only at both ends to a carrier part (22, 8).

15. An apparatus according to claim 14, characterised in that the brake element (33) is attached so that it hangs freely parallel to the plane of the printed circuit board (4).

16. An apparatus according to any of claims 12 to 15, characterised in that the brake element comprises two flat bands (36) having arranged between them a damping strip (37) of soft or elastic material.

17. An apparatus according to any of claims 12 to 16, characterised in that the brake element is a plate-shaped component (53) which is connected to its carrier part (46) by a leaf spring (55) extending parallel to said component.

18. An apparatus according to any of claims 1 to 17, characterised in that the bottom (87) of the magazine (14) is arranged substantially in the plane of the printed circuit board (4).

19. An apparatus according to any of claims 1 to 18, characterised in that,
at least the brakes (167, 168) effective in the plane of the printed circuit board (4) have in each case brake rails (169, 171) extending parallel to the associated direction of displacement (X, Y) movable transversely of the plane of the displacement directions (X, Y), each of which brake rails is displaceable against the associated moveable guide part (8, 141, 142) in the direction of displacement (X, Y) concerned.

20. An apparatus according to claim 19, characterised in that brake elements (181, 184), preferably of hard rubber or the like, are arranged between the brake rails (169, 171) and guide parts (8, 141, 142) associated with one another.

21. An apparatus according to claim 20, the displaceable carrier (12, 18) being arranged on a guide arm (8) that is displaceable parallel to the plane of the printed circuit board (4) by means of a crosshead (141) in a cross guide (131), characterised in that the brake element (181) cooperating with the guide arm (8) is arranged on an arm (179) that is connected to the crosshead (141) in a vertically flexible manner.

22. An apparatus according to any of claims 19 to 21, characterised in that the brake rails (169, 171) are arranged to be vertically movable on cross beams (172, 173) arranged transversely between the side walls (22) of the apparatus (2).

23. An apparatus according to any of claims 20 to 22, characterised in that the brake rails (169, 171) can be moved by electromagnets (165, 166) arranged in each case at both ends.

24. An apparatus according to any of claims 1 to 23, the displaceable carrier (12, 18) being arranged on a guide arm (8) that is displaceable parallel to the plane of the printed circuit board (4) by means of a crosshead (141) in a cross guide (131), characterised in that to guide the cross head (141) there are provided a main guide rail (132) in the form of a rod (137) with two guide planes aligned transversely to one another and an auxiliary guide rail (133) with only one guide plane which extends substantially parallel to a plane longitudinally intersecting the guide rails (132, 133).

25. An apparatus according to claim 24, characterised in that the two guide rails (132, 133) are rigidly connected together.

26. An apparatus according to any of claims 1 to 24, characterised in that pairs of rollers (144 to 151) are provided for guidance on the guide rails (133, 137), of which at least some rollers are mounted on transversely bendable limbs (153) or ribs (156), preferably weakened by recesses (138, 139, 155), and in that the guidance distance (b, c) of the rollers is adjustable by set screws (157, 158) transversely tensioning the limbs or ribs.

## Revendications

1. Appareil (2) pour le montage et/ou le soudage ou le collage de composants (15) électroniques, notamment de composants CMS, sur des cartes à circuit imprimé (4), comportant un premier support (3) pour au moins une carte à circuit imprimé (4), un deuxième support (12, 18) pour un composant (15), l'un des supports (12, 18) pouvant être déplacé parallèlement au plan de la carte à circuit imprimé (4) dans deux directions de déplacement (X, Y) mutuellement transversales et l'un des supports (3, 12, 18) pouvant être déplacé transversalement à la carte à circuit imprimé (4) par rapport à l'autre support (3), ainsi qu'un magasin (14) pour les composants (15),
caractérisé par le fait
qu'un frein (28, 29; 167, 168) est associé au support (12, 18) pouvant se déplacer parallèlement au plan de la carte à circuit imprimé (4) pour l'une des deux directions de déplacement (X, Y) ou pour chacune des deux directions de déplacement (X, Y), lequel frein peut être mis en service de manière sélective ou est mis en service lorsqu'il existe un contact entre le support (12, 18) mobile, le composant (15) et la carte à circuit imprimé (4).

2. Appareil (2) pour le montage et/ou le soudage ou le collage de composants (15) électroniques, notamment de composants CMS, sur des cartes à circuit imprimé (4), comportant un premier support (3) pour au moins une carte à circuit imprimé (4), un deuxième support (12, 18) pour un composant (15), l'un des supports (12, 18) pouvant être déplacé parallèlement au plan de la carte à circuit imprimé (4) dans deux directions de déplacement (X, Y) mutuellement transversales et l'un des supports (3, 12, 18) pouvant être déplacé transversalement à la carte à circuit imprimé (4) par rapport à l'autre support (3), ainsi qu'un magasin (14) pour les composants (15), ou appareil selon la revendication 1,
caractérisé par le fait
qu'un frein (51) est associé au support (12, 18) dans sa direction de déplacement (Z) transversalement au plan de la carte à circuit imprimé (4), lequel frein peut être mis en service de manière sélective ou est mis en service dans une position dans laquelle il existe un contact entre ledit support (12, 18) mobile, le composant (15) et la carte à circuit imprimé (4).

3. Appareil selon la revendication 1 ou 2, caractérisé par le fait que le frein concerné (28, 29; 167, 168) peut être mis en service ou les deux freins peuvent être mis en service séparément ou simultanément par l'actionnement d'un contacteur, notamment d'un contacteur à commande manuelle ou à commande au pied.

4. Appareil selon les revendications 1 à 3, caractérisé par le fait que le deuxième support (12, 18) pour le composant (15) peut être déplacé dans les directions de déplacement (X, Y) parallèles au plan de la carte à circuit imprimé (4) et de préférence également dans la direction de déplacement (Z) transversale au plan de la carte à circuit imprimé (4).

5. Appareil selon l'une des revendications 1 à 4, caractérisé par le fait que le support (12, 18) mobile est télescopique dans la direction transversale au plan de la carte imprimée (4) et qu'au moins l'un des freins (28, 29) qui agissent dans les directions de déplacement (X, Y) parallèles au plan de la carte à circuit imprimé (4) est mis en service lors d'un déplacement relatif des éléments télescopiques (8, 12).

6. Appareil selon l'une des revendications 1 à 5, le support (12, 18) mobile étant disposé sur un bras de guidage (8) qui, au moyen d'un élément de guidage (23), peut être déplacé dans un système de guidage en croix (9) parallèlement au plan de la carte à circuit imprimé (4), caractérisé par le fait que les freins (28, 29) qui agissent dans les directions de déplacement (X, Y) parallèles au plan de la carte à circuit imprimé (4) sont disposés dans la région de l'élément de guidage (23).

7. Appareil selon la revendication 6, caractérisé par le fait que le frein (29) qui est actif dans la direction de déplacement (Y) qui s'étend le long du bras de guidage (8) agit entre l'élément de guidage (23) et le bras de guidage (8).

8. Appareil selon l'une des revendications 1 à 7, caractérisé par le fait que le deuxième support est une tête de montage (12) pourvue d'un boîtier (46) qui peut se déplacer dans un moyen de guidage (39) vertical sur un bras de guidage (8) mobile parallèlement au plan de la carte à circuit imprimé (4), caractérisé par le fait que le frein (51) qui est actif dans la direction de déplacement (Z) transversale au plan de la carte à circuit imprimé (4) est disposé dans le boîtier (46).

9. Appareil selon l'une des revendications 1 à 8, caractérisé par le fait que le frein (28, 29, 51) est formé chaque fois d'un électroaimant (31) qui coopère avec une surface ferromagnétique.

10. Appareil selon l'une des revendications 5 à 9, caractérisé par le fait que le déplacement relatif entre les éléments télescopiques (18, 46) du deuxième support (12) sont déterminés au moyen d'un contacteur (61) électrique qui commute l'électro-aimant (31).

11. Appareil selon l'une des revendications 1 à 10, caractérisé par le fait que le frein (51) actif dans la direction de déplacement (Z) transversale au plan de la carte à circuit imprimé (4) est mis en service par un contacteur (117) électrique.

12. Appareil selon l'une des revendications 9 à 11, caractérisé par le fait que la surface ferromagnétique est aménagée sur un organe de freinage (33, 34, 53) en forme de ruban ou de barreau.

13. Appareil selon la revendication 12, caractérisé par le fait que l'électro-aimant (31) est disposé au-dessous de l'organe de freinage (33, 34, 53) en forme de ruban ou de barreau.

14. Appareil selon la revendication 12 ou 13, caractérisé par le fait que l'organe de freinage (33, 34 , 53) en forme de ruban ou de barreau qui est fixé à une extrémité seulement ou aux deux extrémités à un élément de support (22, 8).

15. Appareil selon la revendication 14, caractérisé par le fait que l'organe de freinage (33) est fixé pendant librement parallèlement au plan de la carte à circuit imprimé (4).

16. Appareil selon l'une des revendications 12 à 15, caractérisé par le fait que l'organe de freinage est constitué par deux rubans plats (36) entre lesquels est placée une bande isolante (37) en matériau souple ou élastique.

17. Appareil selon l'une des revendications 1 à 16, caractérisé par le fait que l'organe de freinage est un élément (53) en forme de plaque qui est relié à sa partie support (46) par une lame de ressort (55) qui s'étend parallèlement audit élément.

18. Appareil selon l'une des revendications 1 à 17, caractérisé par le fait que le fond (87) du magasin (14) est disposé sensiblement dans le plan de la carte à circuit imprimé (4).

19. Appareil selon l'une des revendications 1 à 18, caractérisé par le fait qu'au moins les freins (167, 168) qui sont actifs dans le plan de la carte à circuit imprimé (4) présentent des rails de freinage (169, 171) qui s'étendent parallèlement à la direction de déplacement (X, Y) concernée, peuvent se déplacer transversalement au plan des directions de déplacement (X, Y) et qui peuvent se déplacer chacun par rapport à l'élément de guidage (8, 141, 142) correspondant mobile dans la direction de déplacement (X, Y) concernée.

20. Appareil selon la revendication 19, caractérisé par le fait que des éléments de freinage (181, 184) de préférence en caoutchouc dur ou analogue sont disposés entre les rails de freinage (169, 171) associés et les éléments de guidage (8, 141, 142).

21. Appareil selon la revendication 20, le support (12, 18) mobile étant monté sur un bras de guidage (8) qui, au moyen d'un élément de guidage (141), peut être déplacé dans un système de guidage en croix (131) parallèlement au plan de la carte à circuit imprimé (4), caractérisé par le fait que l'élément de freinage (181) qui coopère avec le bras de guidage (8) est disposé sur un bras (179) qui est lié à l'élément de guidage (141) avec possibilité de flexion dan la direction verticale.

22. Appareil selon l'une des revendications 19 à 21, caractérisé par le fait que les rails de freinage (169, 171) sont tenus avec possibilité de déplacement dans la direction verticale sur des traverses (172, 173) qui sont disposées transversalement entre les parois latérales (22) de l'appareil (2).

23. Appareil selon l'une des revendications 20 à 22, caractérisé par le fait que les rails de freinage (169, 171) peuvent être déplacés chacun au moyen d'électro-aimants (165, 166) disposés aux deux extrémités.

24. Appareil selon l'une des revendications 1 à 22, le support (12, 18) mobile étant disposé sur un bras de guidage (8) qui, au moyen d'un élément de guidage (141), peut être déplacé dans un système de guidage en croix (131) parallèlement au plan de la carte à circuit imprimé (4), caractérisé par le fait qu'il est prévu pour le guidage de l'élément de guidage (141) un rail de guidage principal (132) qui se présente sous la forme d'une barre (137) avec deux plans de guidage tournés l'un vers l'autre et un rail de guidage auxiliaire (133) avec un seul plan de guidage lesquels rails de guidage s'étendent sensiblement parallèlement à un plan qui coupe longitudinalement les rails de guidage (132, 133).

25. Appareil selon la revendication 24, caractérisé par le fait que les deux rails de guidage (132, 133) sont liés rigidement entre eux.

26. Appareil selon l'une des revendications 1 à 24, caractérisé par le fait qu'il est prévu des paires de galets (144 à 151) qui assurent le guidage sur les rails de guidage (133, 137) et parmi lesquels quelques galets au moins sont montés sur des bras (153) ou des corps (156) flexibles dans la direction transversale ou de préférence affaiblis par des entailles (138, 139, 155) et par le fait que la distance de guidage (b, c) des galets peut être réglée par les vis de réglage (157, 158) qui déforment les bras ou les corps dans la direction transversale.
